Europäisches Patentamt

European Patent Office

Office européen des brevets

(11) Publication number: **0 047 627**
A1

# EUROPEAN PATENT APPLICATION

(21) Application number: **81303999.7**

(22) Date of filing: **02.09.81**

(51) Int. Cl.³: **G 03 F 7/26**

(30) Priority: **09.09.80 GB 8029033**

(43) Date of publication of application: **17.03.82**
**Bulletin 82/11**

(84) Designated Contracting States: **DE FR GB IT NL SE**

(71) Applicant: **Ross, Calum, 5 Windsor Terrace Newton
Stewart, Wigtownshire (GB)**
Applicant: **Mallinson - Mackenzie, Ethel; McGuffie,
William; Mackenzie, Robert John, Trading as
GALLOWAY GRANITE WORKS 13/17 Albert Street
Newton Stewart, Wigtownshire (GB)**

(72) Inventor: **Ross, Calum, 5 Windsor Terrace Newton
Stewart, Wigtownshire (GB)**

(74) Representative: **Szczuka, Jan Tymoteusz et al,
Cruikshank & Fairweather 19 Royal Exchange Square,
Glasgow G1 3AE Scotland (GB)**

(54) **Method of applying an image to a surface and product thereof.**

(57) This invention relates to the production of images on stone surfaces and the like. Known techniques for the reproduction of photographic images are difficult and highly skilled.

The present invention provides a method of producing an image on an abradable surface (2) comprising the steps of optically projecting (6–9) an image (4) onto a layer of photo-sensitive material (3) processing said material so as to produce directly or indirectly a substantially abrasive resistant stencil (10) corresponding to said image (4), and subjecting the surface (2) through said stencil (10) to impact from a stream of high-velocity abrasive particles (13).

## METHOD OF APPLYING AN IMAGE TO

## A SURFACE AND PRODUCT THEREOF.

This invention relates to a method of applying an image to a stone or other more or less hard but abradable surface.

In the production of stone monuments it is from time to time desired to include a pictorial image on the finished stone surface. This can be achieved by the use of chisels to cut the image into the surface. Such a process is however very time consuming and highly skilled and does not lend itself to precise reproduction of photographic images.

It is an object of the present invention to overcome or minimize the above disadvantages and to provide a method for applying photographic images or the like in substantially permanent form to a stone or like surface in a simple and economical manner.

The present invention provides a method of producing an image on an abradable surface comprising the steps of optically projecting an image onto a layer of a photo-sensitive material, processing said material so as to produce directly or indirectly an abrasive resistant stencil corresponding to said image, and subjecting the surface through said stencil to impact from a stream of high-velocity abrasive particles.

By means of the present invention it is possible to closely reproduce a two-tone image on an abradable smooth surface in a relatively simple and economic manner without the need for highly skilled labour.

In one form of the invention the photo-sensitive material is processed to produce said stencil directly. In this case a suitable material, usually an emulsion, is one in which either a positive or negative image can be formed in a layer of the material by production of substantially hard abrasive resistant areas, the remaining parts of the material layer being readily removable, for example by dissolution by suitable solvents. Conveniently an emulsion of the type commonly used in the process known as screen-printing is used. Preferably an emulsion in which on exposure to an ultra-violet light source (or other light source depending upon the nature of the photosensitive component of the emulsion) parts of the material become substantially hard and insoluble, the remaining, unexposed, areas being soluble, conveniently water-soluble. Suitable materials include Polyvinyl Alcohol (PVA) based ammonium or potassium dichromate or diazo sensitized emulsions such as are used in screen-printing. One example of such an emulsion that is commercially available is "Seriset-B" which is available from Sericol Group Limited, of 24 Parsons Green Lane, London, England. Similar sensitized emulsions with other bases such as Polyvinylacetate, Polyacrylamide, Hydroxyethylcellulose, hydroxypropyl cellulose, polyvinylpymolidone, and gelatine, may also be used. Although suitable materials are usually in the form of emulsions, other materials which may be used include those used on polymer printing plates such as are available from the Dupont Co. (Buffalo, New York, U.S.A.).

In this form of the invention, the emulsion may conveniently be applied to the stone (or other) surface prior to exposure and the stencil formed directly on the stone surface. Alternatively the emulsion could be initially applied to a carrier or support substrate, conveniently a plastics support film which is substantially non-resistant to abrasion, and the stencil formed from the emulsion on the support film. The support film together with the stencil may then be applied to the stone surface with the aid of a suitable adhesive if necessary, and exposed to the stream of high velocity abrasive particles. The stream will quickly penetrate through the film and attack those parts of the stone surface not shielded by the hardened areas of the emulsion.

In another form of the invention the emulsion is processed to form a preliminary stencil which need not be abrasive resistant but is then used to produce a stencil which is abrasive resistant by means of a further processing, for example, by screen-printing. Naturally in this case the original photo-sensitive material need not be capable of producing an abrasive resistant stencil. Also the final abrasive resistant stencil need not be produced directly from a photo-sensitive material but can be obtained using other, non-photo-sensitive, "inks" which can be used in screen-printing to produce an image which can be stabilized into an abrasive resistant stencil by appropriate processing such as drying, heat treatment, electromagnetic radiation treatment, and/or chemical stabilization. Suitable "inks" include epoxy resin based two-component inks in which a base component is mixed with a catalyst and then hardened over a period of time after printing using the mixture. Suitable materials of this type are known for use in the production of printed circuit boards via a screen printing step. One commercially available example of this type of product is known as "Polyscreen" (available from the Sericol Group Limited - see above).

Nevertheless if desired both the preliminary stencil and the final stencil could be produced using a photo-sensitive emulsion such as those referred to above. This would still have the advantage that only a single exposure to the original photographic image (see below) would be required (for the preliminary stencil production) in obtaining a large number of the final stencils which can be very simply produced by conventional screen printing techniques. This may be useful where it is desired to supply a number of stone processors with a given stencil and/or to replace stencils which have become worn out.

The image may be projected on to the photo-sensitive emulsion by placing a photographic negative or positive as appropriate (see below) of the subject against the emulsion and exposing the emulsion directly through said negative or positive. Alternatively the image could be projected remotely for example, through a photographic enlarger.

When the unshielded parts of the stone surface have been abraded to a sufficient depth, which can be readily determined by trial and error, the stream of abrasive particles will be removed and the stencil may then be removed from the surface mechanically and/or chemically.

Although in one convenient form of the invention, in which the "exposed" parts of the emulsion are hardened to form the stencil and thus correspond to non-abraded portions of the stone surface so that it is necessary to employ a negative of the subject when "exposing" the emulsion to obtain a positive image on the stone surface. It will be appreciated that a positive could be used at the "exposure" stage where the unexposed parts of the emulsion form the solid parts of the stencil. It will also be appreciated that where more than one stencil stage is involved image reversal will normally occur. Those skilled in the art will obviously be aware of the need for the correct choice of positive or negative form of initial image in accordance with the occurence of any image reversal(s) during the various stages of the process and the desired form of final image on the substrate used.

Naturally, the image produced on the stone surface will be visually most effective where there is a substantial contrast between the abraded and non-abraded portions of the stone surface. Advantageously therefore the technique is applied to a polished stone surface, for example granite of the type which is naturally grey in tone but appears black when polished.

It will be appreciated that the above method is substantially limited to the representation of images in light and dark tones only although intermediate tones can, if desired, be obtained by the use of suitable halftone screens or line conversion screens as used in printing.

Naturally this invention also extends to a stone surface having an image thereon produced by a method according to the present invention.

The invention naturally extends to synthetic and reconstituted stone material surfaces and can also be applied to other materials whose surfaces can be abraded to produce contrasting surface areas, for example, glass, metal especially polished metal, glazed materials and the like.

Further preferred details of the invention will appear from the following description given by way of example of one embodiment of the method of the invention illustrated with reference to the accompanying drawings in which:

Fig. 1 is a schematic side view of the exposure of a polished gravestone coated with an emulsion, to a projected photographic image;

Fig. 2 is a schematic side view of the sandblasting of the stone through the developed emulsion; and

Fig. 3 is a schematic side view of the finished stone after removal of the residual emulsion coating.

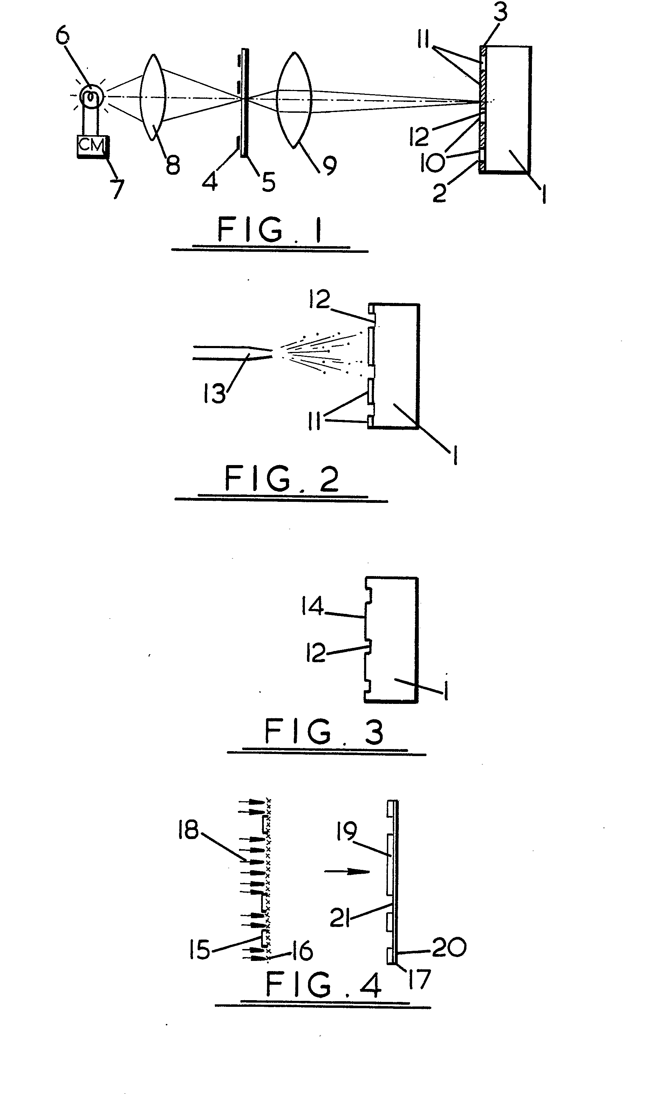

Fig. 1 shows a gravestone 1, of so-called "black" granite which is naturally grey but appears black when polished, with a polished front surface 2 which is coated with a layer of photo-sensitive emulsion such as Seriset-B (see above) 3. A negative photographic image 4 conveniently recorded on photographic film 5 is projected onto the emulsion 3 using a photographic enlarger (shown schematically) and including an ultra-violet light source 6 provided with conventional power and control means (CM) 7, a condenser 8 and an objective lens 9.

The areas 10 of the emulsion 3 which have been exposed to the ultra-violet light become relatively hard and insoluble. The emulsion is then 'developed' by washing away the remaining, unexposed, parts 11 of the emulsion 3 with water to leave the underlying parts 12 of the polished stone surface 2 uncovered (see Fig. 2), the remaining 'exposed' parts of the emulsion now constituting in effect a stencil.

The front surface of the stone 1 is then sand blasted using conventional sandblasting apparatus 13 (shown only schematically) and the uncovered parts 12 of the polished surface 2 gradually eroded away until they revert to the natural grey appearance of the stone 1.

The residual (exposed) parts 10 of the emulsion are then removed with the aid of physical and/or chemical break-up e.g. by treatment with a strong bleach or paint stripper, to uncover the remaining parts 14 of the polished surface 2 which have been protected against abrasion by the overlying (exposed) parts 10 of the emulsion, to produce a two-tone image made up of the contrasting polished black and grey abraded surfaces of the stone.

As used herein the expression 'substantially abrasive resistant' means that the (hardened) material is substantially unaffected by sandblasting or the like or is at least abraded only relatively slowly so that the abrasive particles do not penetrate the layer thereof until the required depth of abrasion in the surface has been reached. In general it is desirable that the layer should not be too thin as this can result in undue fragility and not too thick as this results in increased consumption of the material and may lead to some loss of definition and quality of the image on the surface under treatment. In practice a suitable thickness of the layer is of the order of 1 mm or thereabouts e.g. from 0.5 to 1 mm. The depth to which abrasion is carried out in the surface will preferably be more or less close to the minimum required to produce an acceptable degree of visual contrast between the abraded and non-abraded surfaces and will often be less than 1 mm. A greater depth of abrasion for example up to 5 mm may be used where maximum image permanence under weathering is required though in such cases it is likely to be necessary to use a thicker stencil.

Finally Fig. 4 schematically illustrates the alternative two-stage procedure in which an intermediate stencil 15 is formed on a silk screen or similar material 16 in a layer of the above described photo-sensitive emulsion on the screen in analogous manner to the production of the stencil 11 on the granite block surface 2 in Figs. 1 to 3. A final stencil is then produced by printing through the screen 16 around the intermediate stencil portions 15 onto a paper substrate 17 in conventional silk screen printing manner but using an 'ink' 18 comprising a further quantity of the above-described photo-sensitive material. The resulting printed image is then exposed to ultra violet light for a period of time sufficient to harden it into an abrasive resistant stencil 19. The paper substrate or carrier 17 has a self adhesive backing covered by a protective film 20 which is then removed and the backing placed on a stone or other surface to be treated. Sandblasting may then be started and very quickly removes the paper carrier 21 in the open parts of the stencil 19 and then proceeds to abrade the stone surface itself thereunder – but not under the stencil 19 itself.

In connection with the use of Seriset-B it may be noted that the PVA content thereof can be adjusted if desired to modify the handling and hardening properties thereof as required.

0047627

CLAIMS

1. A method of producing an image on an abradable surface (2) comprising the steps of optically projecting (6-9) an image (4) onto a layer of photo-sensitive material (3) processing said material so as to produce directly or indirectly a substantially abrasive resistant stencil (10) corresponding to said image (4), and subjecting the surface (2) through said stencil (10) to impact from a stream of high-velocity abrasive particles (13).

2. A method as claimed in Claim 1 wherein after exposure of said layer of photo-sensitive material (3) to said image (4), one of the exposed and unexposed parts (10,11) of said layer becomes more or less soluble than the other (11).

3. A method according to Claim 2 wherein said layer of photo-sensitive material (3) is developed by washing away the more soluble one (11) of the exposed and unexposed parts (10,11) thereof with a solvent to produce a stencil made up of the less soluble one (10) of said parts (10,11), said photo-sensitive material (3) being such that said less soluble one of said parts is substantially abrasive resistant after exposure to said image (4).

4. A method according to Claim 3 which includes the step of applying said layer of material (3) to said abradable surface (2) prior to exposure of the material (3) to said image (4) whereby said stencil is formed directly on said surface (2).

5. A method according to Claim 2 wherein said layer of photo-sensitive material is developed by washing away the more soluble one (11) of the exposed and unexposed parts (10,11) thereof to produce an intermediate stencil made up of the other of said parts (10,11) and which method includes the subsequent steps of carrying out a screen printing process through said intermediate stencil using an ink material which can be physically and/or chemically hardened into a substantially abrasive resistant form, and physically and/or chemically treating said ink material to harden it so as to produce a said substantially abrasive resistant stencil.

6.    A method according to Claim 5 wherein is used a photo-sensitive ink material which hardens after exposure to light.

7.    An abradable surface having an image thereon produced from a photographic image by a method according to any one of the preceding claims.

1/1                    0047627

FIG. 1

FIG. 2

FIG. 3

FIG. 4

## DOCUMENTS CONSIDERED TO BE RELEVANT

| Category | Citation of document with indication, where appropriate, of relevant passages | Relevant to claim |
|---|---|---|
| X | FR - A - 374 243 (J.H. FREY and E. FREY)<br>* Whole document *<br>-- | 1-7 |
| X | DE - C - 390 165 (J. RIEDER)<br>* Whole document *<br>-- | 1-7 |
| X | GB - A - 571 106 (KODAK)<br>* Whole document *<br>& FR - A - 947 128<br>-- | 1-7 |
| | US - A - 2 548 567 (H.C. STAEHLE)<br>* Claims *<br>-- | 1-7 |
| | FR - A -1 356 597 (IWATANI SANGYO)<br>* The abstract *<br>& CH - A - 432 178<br>-- | 5 |
| A | DE - C - 26 514 (J.J. SACHS)<br>* Whole document *<br>----- | 1 |

**CLASSIFICATION OF THE APPLICATION (Int. Cl.³)**

G 03 F 7/26

**TECHNICAL FIELDS SEARCHED (Int. Cl.³)**

G 03 F 7/26

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 18-11-1981 | RASSCHAERT |

EPO Form 1503.1 06.78